# EUROPÄISCHE PATENTSCHRIFT

(11) **EP 2 375 515 B1**
(45) Veröffentlichungstag und Bekanntmachung des Hinweises auf die Patenterteilung: **05.09.2018**
(21) Anmeldenummer: 11002778.6
(22) Anmeldetag: 02.04.2011
(51) Int. Cl.: H02B 1/03, G01R 22/06

(54) **Adapter für einen elektronischen Haushaltszähler**
Adapter for an electronic domestic meter
Adaptateur pour un compteur électronique domestique

(30) Priorität: 08.04.2010 DE 202010004696 U; 28.04.2010 DE 202010006202 U
(43) Veröffentlichungstag der Anmeldung: 12.10.2011
(73) Patentinhaber: Braun, Werner, 74906 Bad Rappenau (DE)
(72) Erfinder: Braun, Werner, 74906 Bad Rappenau (DE)
(74) Vertreter: Schmid, Barbara

(56) Entgegenhaltungen:
- EP-A2- 1 431 765
- DE-A1- 2 256 373
- DE-A1- 10 216 913
- DE-A1-102004 004 234
- DE-A1-102004 025 164
- DE-A1-102004 025 605
- DE-A1-102006 040 094
- DE-B3-102004 051 817
- DE-B3-102004 051 818
- JP-A- 2009 150 753
- JP-U- S 627 077

## Beschreibung

### TECHNISCHES GEBIET

Die Erfindung betrifft einen Adapter als Befestigungs- und Kontaktiereinrichtung (BKE) für einen elektronischen Haushaltszähler (eHZ).

An dem an einer elektrischen Stromversorgung angeschlossenen Adapter kann ein elektronischer Haushaltszähler mit seinen auskragenden Kontaktzungen und Befestigungsfüßen angedockt werden. Über den Haushaltszähler können dann verbrauchsrelevante Daten erfasst, gespeichert, abgelesen und durch zusätzliche Einrichtungen auch weitergeleitet werden.

Der elektronische Haushaltszähler löst im Zuge des Wandels im Energiemarkt die bisherigen mechanischen Ferraris-Zähler ab. Der elektronische Haushaltszähler soll den Privat- und Gewerbekunden durch zeitnahe Verbrauchsinformationen und variable Tarife für den bewussten Umgang mit Energie sensibilisieren.

### STAND DER TECHNIK

Die seit vielen Jahren verwendeten Ferraris-Zähler werden auf einem sogenannten Zählerkreuz, welches in Zählerschränken und auf Zählertafeln aufgebracht ist, montiert und befestigt. Diese Befestigungsart ist als sogenannte Dreipunktbefestigung zum Standard geworden und in allen technischen Anschlussbedingungen der Energieversorger zur üblichen Vorschrift und Montageart geworden. Diese Dreipunktbefestigung besteht aus einem obigen mittigen und einem unten links und unten rechts vorhandenen Befestigungsloch, durch das unter Einsatz von sogenannten Zählerschrauben der Ferraris-Zähler an drei Punkten auf dem Zählerkreuz befestigt werden kann.

Bei diesen Ferraris-Zählern erfolgt die Verbrauchszählung in einem Bereich des Zählers, in dem der elektrische Strom noch ungezählt vorhanden ist. Der Zugriff zu diesem ungezählten Zählerplatzbereich ist nur ausgewählten und durch den jeweiligen Energieversorger zugelassenen elektrischen Fachbetrieb erlaubt. Es hat sich herausgestellt, dass eine solche Plombierung insbesondere auch unter dem Gesichtspunkt der Manipulationssicherheit als sicher zu bezeichnen ist.

Die heute bekannten elektronischen Haushaltszähler können einerseits, ohne entsprechenden Adapter, bei einer Neuinstallation der gesamten Stromversorgung direkt an einem Zählerplatz angeordnet werden. Darüber hinaus sollen elektronische Haushaltszähler auch die vorhandenen Ferraris-Zähler nach und nach ersetzen; das bedeutet, dass die vorhandenen Zählerplätze mit ihrer Dreipunkbefestigung auch für elektronische Haushaltszähler verwendbar sein müssen. Zu diesem Zweck ist es bekannt, einen Adapter an der Dreipunktbefestigung anzubringen und zwar in der gleichen Art und Weise, wie es auch bei einem Anschluss eines Ferraris-Zählers der Fall wäre.

Bekannte elektronische Haushaltszähler sind so mit ihren Kontaktzungen und Befestigungsfüßen ausgebildet, dass sie in einer ersten Richtung, senkrecht auf die Berührfläche des Adapters hin, auf den Adapter aufgesteckt und anschließend in einer dazu senkrechten zweiten Richtung, die parallel zur Berührfläche des Adapters mit dem elektronischen Haushaltszähler verläuft, verschoben werden. Das Andocken des elektronischen Haushaltszählers an dem Adapter erfolgt damit in zwei aufeinander senkrecht stehenden Bewegungsrichtungen. Der endgültig am Adapter angedockte elektronische Haushaltszähler wird dann durch eine Verplombung mittels eines Plombendorns, der quer durch den elektronischen Haushaltszähler geht und in den Adapter eingreift, lagemäßig am Adapter fixiert. Damit ist der elektronische Haushaltszähler verplombungssicher an dem Adapter gehalten. Diese Verplombungstechnik greift in einen Bereich des Adapters ein, in dem der elektrische Strom bereits vom Zähler erfasst wurde; die Verplombung greift also nicht in den dem elektronischen Haushaltszähler vorgelagerten Bereich ein, in dem noch ungezählter Strom, wie in der Regel dreiphasiger Drehstrom, ansteht. Es ist zu befürchten, dass Manipulationen im Bereich des gezählten Stroms eher vorgenommen werden als solche Manipulationen im ungezählten Bereich; diese Annahme rechtfertigt sich durch die guten Erfahrungen mit der Verplombungstechnik beim Ferraris-Zähler, die, wie bereits ausgeführt, im noch ungezählten Bereich des Zählplatzes erfolgt. Adapter für Stromzähler sind aus DE 10 2006 040 094 und DE 10 2004 051 817 bekannt.

### DARSTELLUNG DER ERFINDUNG

Ausgehend von diesem Stand der Technik liegt der Erfindung die Aufgabe zugrunde, einen Adapter bereitzustellen, der wirtschaftlich günstig hergestellt und möglichst einfache, betriebs- und manipulationssicher montiert werden kann.

Diese Erfindung wird durch die Merkmale des Hauptanspruchs gelöst. Sinnvolle Weiterbildungen der Erfindung sind Gegenstand von sich daran anschließenden weiteren Ansprüchen.

Die Erfindung beinhaltet, dass der elektronische Haushaltszähler durch eine Steck-Bewegung lediglich in einer einzigen Richtung auf den Adapter hin bei demselben angedockt werden kann. Durch eine mechanische Verriegelung für den an dem Adapter kontaktmäßig aufsitzenden elektronischen Haushaltszähler kann dann die angedockte Lage des Zählers an dem Adapter gesichert werden. Die Betätigungseinrichtung für diese mechanische Verriegelungsvorrichtung wird unter einer Abdeckung gleichsam versteckt, die durch eine Plombierung geschützt wird. Diese dem Grunde nach bekannte Abdeckung schützt eine Anschließvorrichtung, die dem elektronischen Haushaltszähler vorgelagert an dem Adapter vorhanden ist und die die Zugangs- und Abgangsleitungen der elektrischen Leitungsverbindungen des Adapters abdeckt.

Der elektronische Haushaltszähler wird damit durch eine Verplombung geschützt, die im ungezählten Bereich des betreffenden Zählerplatzes vorhanden ist. Es ist zu erwarten, dass sich diese Verplombungstechnik als genauso wenig manipulierbar herausstellt, wie es sich in der Vergangenheit in Zusammenhang mit der Verplombungstechnik der Ferraris-Zähler erwiesen hat.

Der erfindungsgemäße Adapter hat dadurch, dass die Kontakte des elektronischen Haushaltszählers nur noch in entsprechende Gegenkontakte hineingesteckt und nicht mehr verschoben werden müssen, den Vorteil, dass die Kontakte wesentlich stärker dimensioniert werden können. Es hat sich herausgestellt, dass Stromstärken bis etwa 100 Ampere durch lediglich verstärkte Kontakte, praktisch ohne sonstigen Umbau des Adapters, übertragen werden können.

Die Verriegelungsvorrichtung kann, wie in der Zeichnung beispielhaft dargestellt, durch ein als Schiebeplatte ausgebildetes Schiebeglied konstruktiv einfach verwirklicht werden. Mit der Schiebeplatte können die Füße des am Adapter angedockten Zählers lagefixiert gehalten oder nicht gehalten werden; also verriegelt oder entriegelt werden. Im Ausführungsbeispiel werden die vier Füße eines elektronischen Haushaltszählers durch eine gemeinsame Schiebeplatte verriegelt oder entriegelt. Es wäre auch möglich, ein Schiebeglied nur auf einen oder insbesondere diagonal angeordnete zwei der vorhandenen Füße des elektronischen Haushaltszählers entsprechend einwirken zu lassen.

Nähere Einzelheiten zu der Ausbildung der Schiebeplatte sind in der Zeichnung dargestellt, auf die ausdrücklich Bezug genommen wird.

An dem Adapter kann eine Kommunikationseinrichtung als elektrische und elektronische Verbindung zwischen einem an dem Adapter erfindungsgemäß angedockten elektronischen Haushaltszähler und Kunden beziehungsweise Betreibern des elektronischen Haushaltszählers angeschlossen oder anschließbar sein. Die Kommunikationseinrichtung kann dabei integriert in dem Adapter vorhanden sein oder kann als vom Adapter separates, ein- oder mehrteiliges Modul an dem Adapter angedockt, wie insbesondere in den Adapter eingeschoben werden.

Um auch bei vom Adapter angenommenem elektronischen Haushaltszähler die elektrische Stromversorgung durch den Adapter hindurch sicherzustellen, kann an der die Zugangs- und Abgangsleitungen des Adapters enthaltenen Anschließvorrichtung eine Zählersteckklemme anschließbar oder angeschlossen sein. An diese an sich bekannte Zählersteckklemme kann dann mittels eines Überbrückungssteckers die unterbrechungsfreie Stromversorgung der an dem Adapter angeschlossenen Verbraucher gewährleistet werden, auch dann, wenn der elektronische Haushaltszähler nicht an dem Adapter angedockt vorhanden ist. Die verplombbare Abdeckung der Anschließvorrichtung kann dann so groß angelegt werden, dass sie auch die Zählersteckklemme mit abdeckt und damit absichert.

Um sicherzustellen, dass bei vom Adapter abgenommenen elektronischen Haushaltszähler die an dem Adapter angeschlossenen mehreren Verbraucher nach wie vor mit elektrischem Strom versorgt werden, kann statt der vorstehend erwähnten Zählersteckklemme, die an die Anschließvorrichtung dazu angeschlossen und dann darüber hinaus noch an der Zählersteckklemme ein Überbrückungsstecker angedockt werden muss, nach einer wesentlichen Weiterbildung der Erfindung, und diese Weiterbildung stellt darüber hinaus eine eigene Erfindung dar, auch unmittelbar an der Anschließvorrichtung eine Überbrückung der in den Adapter hineinführenden und herausführenden Zugangs- und Abgangsleitungen vorgesehen werden. Eine Ausführungsform für eine solche Überbrückung ist in den Figuren dargestellt und im Zusammenhang mit einem Überbrückungsadapter in der entsprechenden Figurenbeschreibung beschrieben. Ob die Anschließvorrichtung noch weitere technische Merkmale enthält, wie sie nachstehend noch beispielhaft beschrieben werden, ist dabei unerheblich; der Überbrückungsadapter braucht nämlich nur zum Überbrücken der Zugangs- und Abgangsleitungen benutzt zu werden.

An der die Zugangs- und Abgangsleitungen des Adapters aufnehmenden Anschließvorrichtung können mehrere Anschlussklemmen vorhanden sein, über die Leitungsverbindung zu einer Kommunikationseinrichtung für den elektronischen Haushaltszähler beziehungsweise zu einer mit einem angeschlossenen elektronischen Haushaltszähler kommunizierenden Kommunikationsschnittstelle des Adapters hergestellt werden können.

Darüber hinaus kann die Anschließvorrichtung eine Anschlussklemme für eine Phasenleitung und zwei Anschlussklemmen für zwei Signalleitungen besitzen, so dass Tarifsteuerungen und Schaltfunktionen an den elektronischen Haushaltszähler übertragen werden können.

Der Adapter besitzt dabei regelmäßig eine Kommunikationsschnittstelle mit dem elektronischen Haushaltszähler. Diese Kommunikationsschnittstelle kann durch eine separate Leitung durch den Adapter hindurch mit einer außen an der Anschließvorrichtung endenden Schnittstelle wie beispielsweise einer RJ10-Buchse verbunden sein.

Die aus dem Betrieb der Ferraris-Zähler bekannte Plombiertechnik, die Plombierung nämlich dort anzubringen, wo noch ungezählter Strom vorhanden ist, wird bei dem erfindungsgemäßen Adapter übernommen. Dies hat den Vorteil, dass eine Laienmontage des elektronischen Haushaltszählers praktisch ausgeschlossen ist. Ein Zählerwechsel ist also nur durch Fachpersonal, das die entsprechende Qualifikation und Zulassung durch den Energieversorger besitzen muss, möglich. Als technischer Vorteil erweist sich ferner, dass die elektrische Verlustleistung im Bereich der Kontaktierung sich im Vergleich zu der bekannten zweiachsigen Steck-Schiebe-Technik vermindert.

Nähere Einzelheiten zu einer Ausbildung des erfindungsgemäßen Adapters und weitere Vorteile und Merkmale der Erfindung sind den in den Ansprüchen ferner angegebenen Merkmalen sowie dem nachstehenden Ausführungsbeispiel zu entnehmen.

### KURZE BESCHREIBUNG DER ZEICHNUNG

Die Erfindung wird im Folgenden anhand des in der Zeichnung dargestellten Ausführungsbeispiels näher beschrieben und erläutert. Es zeigen:
- Fig. 1: eine perspektivisch aneinander gezogene Darstellung eines erfindungsgemäßen Adapters mit einem an ihm andockbaren elektronischen Haushaltszähler,
- Fig. 2: das Unterteil des Adapters der Fig. 1 mit Darstellung seiner Schiebeplatte in einer die Füße des elektronischen Haushaltszählers an dem Adapter verriegelnden Stellung,
- Fig. 3: eine Darstellung ähnlich der von Fig. 2 mit der Schiebeplatte in ihrer die Füße des Adapters entriegelnden Stellung,
- Fig. 4: eine Darstellung des an dem Adapter angedockten elektrischen Haushaltszählers entsprechend Fig. 1, mit einem an der Anschließvorrichtung des Adapters zum Andocken vorgesehenen Überbrückungsadapter nach der Erfindung,
- Fig. 5: den an die Anschließvorrichtung gemäß Fig. 4 angedockten Überbrückungsadapter,
- Fig. 6: eine Seitenansicht des Überbrückungsadapters gemäß Fig. 4, 5,
- Fig. 7: einen Querschnitt längs der Linie 7-7 in Fig. 6,
- Fig. 8: einen Längsschnitt durch den Überbrückungsadapter gemäß Fig. 6,
- Fig. 9: eine weitere Ausführungsform eines erfindungsgemäßen U-förmigen Überbrückungskontakts,
- Fig. 10: einen Längsschnitt durch eine weitere Ausführungsform eines erfindungsgemäßen Adapters, ähnlich der von Fig. 8, mit aus Vierkantstiften jeweils geformten Überbrückungskontakten,
- Fig. 11: eine weitere Ausführungsform eines erfindungsgemäßen U-förmigen Überbrückungskontakts.

### WEGE ZUM AUSFÜHREN DER ERFINDUNG

Ein Adapter 10, an dem ein elektronischer Haushaltszähler 12 kontaktmäßig angedockt werden kann, ist zur Befestigung an einem sogenannten, üblicherweise bei Ferraris-Zählern vorhandenen Dreipunktzählerkreuz vorgesehen. So besitzt der Adapter 10 eine mittige obere Durchgangsöffnung 13, durch die hindurch die in der Zeichnung nicht dargestellte obere standardisierte Befestigungsöffnung eines Dreipunktzählerkreuzes zugänglich ist. Die Durchgangsöffnung ist ein Langloch, um den Adapter 10 vom Dreipunktzählerkreuz abheben zu können, ohne die Mutter von der in die Durchgangsöffnung hineinragenden Befestigungsschraube vollständig abschrauben zu müssen.

Seitlich unten am Adapter 10, und dort im Bereich der an ihm einstückig vorhandenen Anschließvorrichtung 15, die als Anschlussklemmenblock bezeichnet wird und in der die Zugangs- und Abgangsleitungen für die elektrische Stromversorgung des Adapters 10 in den Adapter hinein und aus demselben geführt werden, sind jeweils rechts und links seitlich Befestigungsschlitze 17 vorhanden, von denen in der Zeichnung nur der rechte Befestigungsschlitz 17 erkennbar ist, der das Befestigen des Adapters 10 an dem bereits erwähnten Dreipunktzählerkreuz ermöglicht. Diese Befestigungstechnik für einen Adapter 10 ist an sich bekannt.

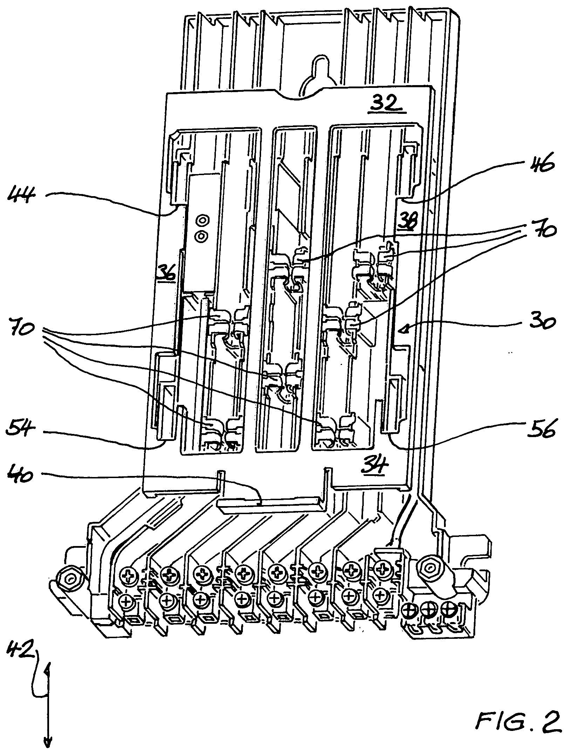

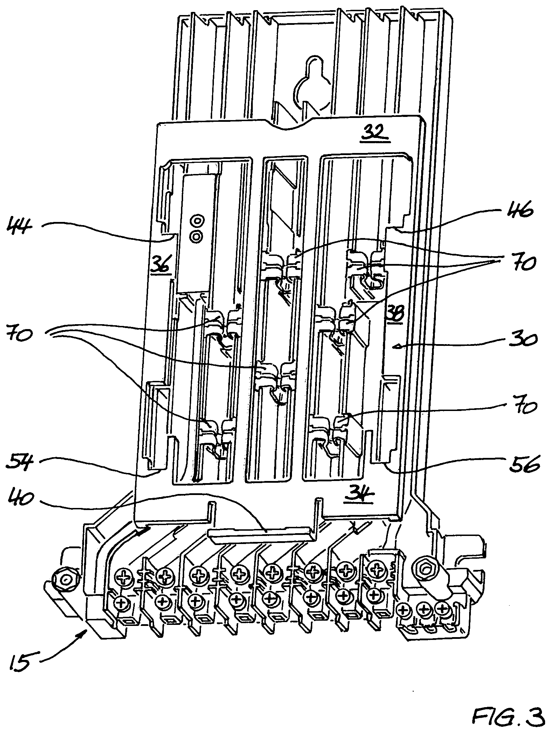

In der Berührfläche 18 des Adapters 10 sind mehrere Öffnungen 20 vorhanden, in die in der Zeichnung nicht dargestellte Kontaktzungen, die von der Unterseite des elektrischen Haushaltszählers 12 nach unten beziehungsweise in Richtung auf die Berührfläche 18 auskragen, beim Andocken des elektronischen Haushaltszählers eintauchen. Über diese Kontaktzungen des elektronischen Haushaltszählers und mit diesen kontaktmäßig verbundenen Gegenkontakten 70 (Fig. 2, 3), die unter diesen Öffnungen 20 im Adapter 10 vorhanden sind, lässt sich die Stromversorgung mit den Zugangs- und Abgangsleitungen und dem Neutralleiter, über die die Stromversorgung mit dem Adapter 10 von außen hergestellt wird, herstellen.

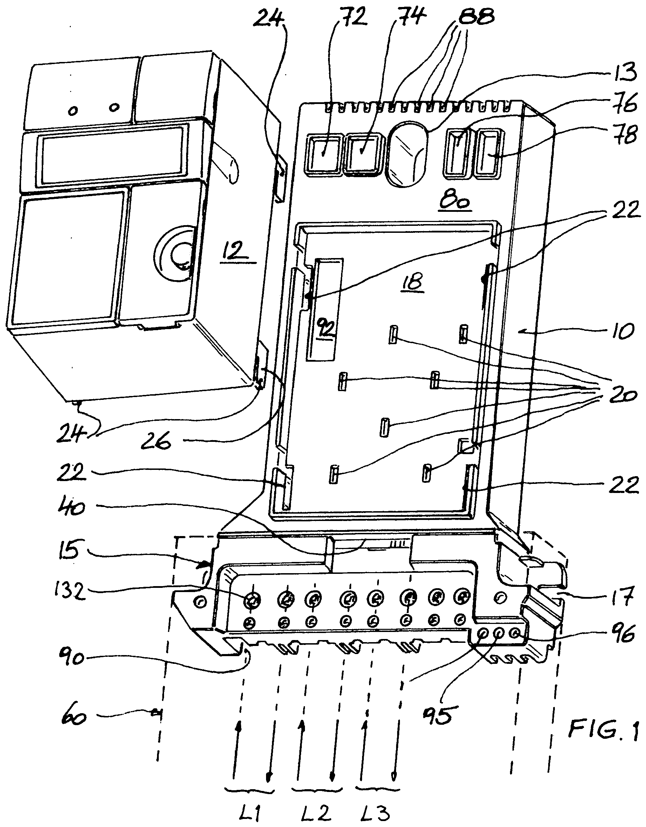

Neben den Öffnungen 20 für die Kontaktzungen des elektronischen Haushaltszählers 12 sind noch vier weitere Öffnungen 22 in der Berührfläche 18 vorhanden. In diese vier Öffnungen 22 tauchen die in diesem Beispielsfall vier L-förmigen Kontaktfüße 24 des elektronischen Haushaltszählers 12, die in Fig. 1 ganz oder teilweise zu erkennen sind, ein. Mit Hilfe einer Schiebeplatte 30 (Fig. 2, Fig. 3) können die vier Füße 24 an dem Adapter 10 lagemäßig fixiert und damit der elektronische Haushaltszähler 12 in seiner an dem Adapter 10 angedockten Stellung festgelegt werden.

Die Schiebeplatte 30 besitzt einen etwa im Grundriss rechteckförmigen Rahmen aus einem oberen und unteren Quersteg 32, 34. Die beiden Querstege werden durch einen linken und rechten Plattensteg 36, 38 biegesteif miteinander verbunden. An dem unteren Quersteg 34 ragt in der Zeichnung nach unten ein Griff 40 heraus. Dieser Griff 40 kann in Richtung des Doppelpfeils 42 - in der Zeichnung nach oben und unten - bewegt und damit die gesamte Schiebeplatte 30 in Richtung des Doppelpfeils 42 hin und her bewegt werden.

In ihrer in Fig. 2 verriegelten Stellung ist der Griff 40 maximal weit nach oben in Richtung des Doppelpfeils 42 verschoben und damit die Schiebeplatte 30 extrem weit nach oben verstellt. Die jeweilige obere Kante 44, 46 in dem mittleren verdickten Bereich 48, 50 der beiden Plattenstege 36, 38 schiebt sich dabei von oben auf die beiden in Fig. 1 oberen Füße 24 des elektronischen Haushaltszählers, und dabei auf die Endflansche 26 dieser L-förmigen Füße 24. Gleichzeitig schiebt sich eine linke und rechte Kante 54, 56 des unteren Quersteges 34 auf die bei der Fig. 1 unteren Füße 24 des elektronischen Haushaltszählers 12. Die vier Füße 24 werden also in der Zeichnung von oben durch die Schiebeplatte 30 abgedeckt. Dies hat zur Folge, dass die Füße nicht aus dem Adapter 10 herausgezogen werden können und damit auch der elektronische Haushaltszähler 12 nicht von dem Adapter 10 weggenommen werden kann.

Durch Verschieben der Schiebeplatte 30 mit Hilfe ihres Griffes 40 nach - in der Zeichnung - unten, welcher Zustand in Fig. 3 dargestellt ist, geben die - in diesem Beispielsfall vier - Kanten 44, 46, 54, 56 der Schiebeplatte 30 dementsprechend die vier Füße 24 des elektronischen Haushaltszählers 12 vollständig frei, so dass der Haushaltszähler 12 mit seinen vier Füßen 24 von dem Adapter 10 weggenommen werden kann. Die Verriegelung könnte auch nur bei einem der Füße oder bei zwei insbesondere diagonal angeordneten Füßen vorgenommen werden.

Während die Schiebeplatte 30 unter der Berührfläche 18 des Adapters 10 vorhanden ist, ragt ihr Griff 40 nach unten aus dem Bereich der Berührfläche 18 heraus und in den Bereich der Anschließvorrichtung 15 hinein. Der Griff 40 ist dabei unter einer in Fig. 1 gestrichelt angedeuteten Abdeckung 60 vorhanden, mit der die Anschließvorrichtung 15 von oben abgedeckt wird und deren Lage in ihrer die Anschließvorrichtung 15 abdeckenden Position durch eine in der Zeichnung nicht dargestellte, üblicherweise bekannte Verplombung gesichert ist. Bei Vorhandensein der Abdeckung 60, die in Fig. 1 angedeutet ist, ist also der Griff 40 nicht von außen zugänglich. Um an dem Griff 40 hantieren und ihn entsprechend verschieben zu können, muss die Abdeckung 60 - und vorher ihre Verplombung - entfernt werden. Dies ist nur Fachpersonal erlaubt, das von dem jeweiligen

Energieversorger die Zulassung besitzen muss, in dem Bereich eines Zählers zu hantieren, in dem noch ungezählter elektrischer Strom vorhanden ist.

In ihrer Kontaktstellung greifen die an dem elektronischen Haushaltszähler 12 vorhandenen Kontaktzungen - wie bereits ausgeführt - in entsprechende Gegenkontakte 70, die in Fig. 2 und 3 dargestellt sind.

Im oberen Bereich des Adapters 10 (Fig. 1) sind eine RJ45-Buchse 72, eine RJ10-Buchse 74, eine USB-Buchse 76 und eine GPS-Buchse 78 als mögliche Schnittstellen einer Kommunikationseinrichtung vorgesehen. Statt dieser Buchsen können auch andere standardisierte Schnittstellen einer Kommunikationseinrichtung vorgesehen sein. Diese Kommunikationseinrichtung ist im vorliegenden Beispielsfall in dem Adapter integriert vorhanden. Es ist allerdings auch möglich, diese Kommunikationseinrichtung als separat vom Adapter 10 ausgebildetes Modul vorzusehen, das dann an dem Adapter 10 angedockt, wie beispielsweise von der Frontseite 80 des Adapters 10 aus oder von seiner oberen Stirnseite 82 aus in den Adapter 10 eingeschoben werden kann.

Im linken unteren Bereich der Anschließvorrichtung 15 ist eine Anschlussmöglichkeit 90 für eine beispielsweise RJ10-Buchse vorhanden. Diese Buchse ist mit der optischen Schnittstelle 92 des Adapters 10 verbunden. Über diese Buchse können dann Daten des elektronischen Haushaltszählers 12 angesteuert werden.

Auf der unteren rechten Seite der Anschließvorrichtung 15 befinden sich drei Anschlussklemmen 94, 95, 96. An diese drei Anschlussklemmen können beispielsweise eine Phase und zwei Signalleitungen angeschlossen werden. Über diese Anschlussklemmen 94, 95, 96 kann damit eine Verbindung mit der optischen Schnittstelle 92 und gegebenenfalls auch mit der vorstehend genannten, im oberen Bereich des Adapters vorhandenen Kommunikationseinrichtung mit ihren verschiedenen Kontaktbuchsen hergestellt werden. Damit kann beispielsweise einerseits der elektronische Haushaltszähler 12 angesteuert und beispielsweise Tarifumschaltungen vollzogen und/ oder Schaltuhrensignale an den elektronischen Haushaltszähler oder an die Kommunikationseinrichtung übertragen werden.

Im oberen Bereich des Adapters 10 (Fig. 1), und dabei auch noch oberhalb der Schnittstellen der Kommunikationseinrichtung sind eine Reihe von nebeneinander angeordneten Lüftungsschlitzen 88 als Wärmeauslassöffnungen vorhanden.

Die Anschließvorrichtung 15 ist normalerweise durch die vorstehend bereits erwähnte, in der Zeichnung nicht dargestellte Abdeckung verschlossen und damit von außen nicht zugänglich. Die Abdeckung wird dann regelmäßig durch eine Verplombung vor unbefugtem Zugriff gesichert. Im vorliegenden Fall ist eine diesbezügliche linke und rechte Plombierschraube 36, 38 in Fig. 1 dargestellt.

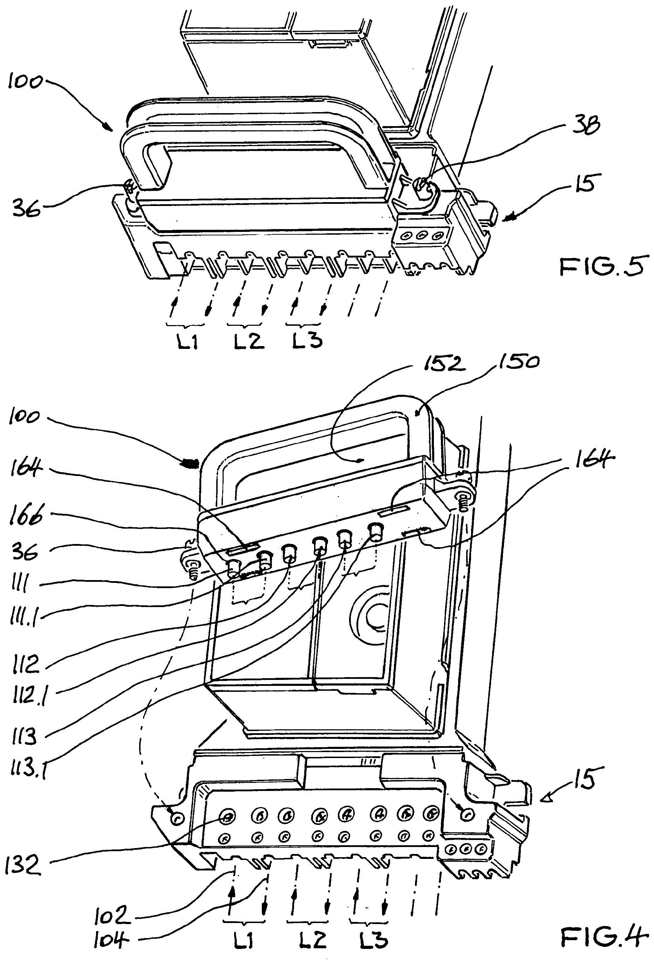

Dieselben beiden Plombierschrauben 36, 38 dienen auch zum Andocken eines Überbrückungsadapters 100 an der Anschließvorrichtung 15 (Fig. 4, 5). Mit Hilfe der Plombierschrauben 36, 38 kann der Überbrückungsadapter 100 an der Anschließvorrichtung 15 statt der vorstehend erwähnten, nicht in der Zeichnung dargestellten Abdeckung für die Anschließvorrichtung 15 befestigt werden.

Der Überbrückungsadapter 100 dient dazu, die im vorliegenden Fall drei Leitungsadern L1, L2, und L3 einer dementsprechenden dreiadrigen Starkstrom-Versorgungsleitung zu überbrücken für den Fall, dass der elektronische Haushaltszähler 12 von dem Adapter 10 abgenommen ist. Die in den Adapter 10 hineinführende Zugangsleitung 102 wird mittels des Überbrückungsadapters 100 im Bereich der Anschließvorrichtung 15 mit der Abgangsleitung 104 der ersten Leitungsader L1 kurzgeschlossen. Entsprechend werden auch die Zugangs- und Abgangsleitungen der anderen beiden Leitungsadern L2 und L3 durch den Überbrückungsadapter 100 kurzgeschlossen. Der Strom fließt in diesem Fall, wenn der elektrische Haushaltszähler 12 von dem Adapter 10 entfernt ist, ungezählt zum Verbraucher.

Der Überbrückungsadapter 100 besitzt mehrere, im vorliegenden Beispielsfall sechs, Kontaktstifte 111, 111.1; 112, 112.1 und 113, 113.1. Die beiden Kontaktstifte 111 und 111.1 dienen zum Überbrücken der Zugangsleitung 102 und der Abgangsleitung 104 der Leitungsader L1. In entsprechender Weise dienen die Kontaktstifte 112 und 112.1 beziehungsweise 113 und 113.1 zum Überbrücken der Zugangs- und Abgangsleitungen der Leitungsader L2 beziehungsweise L3.

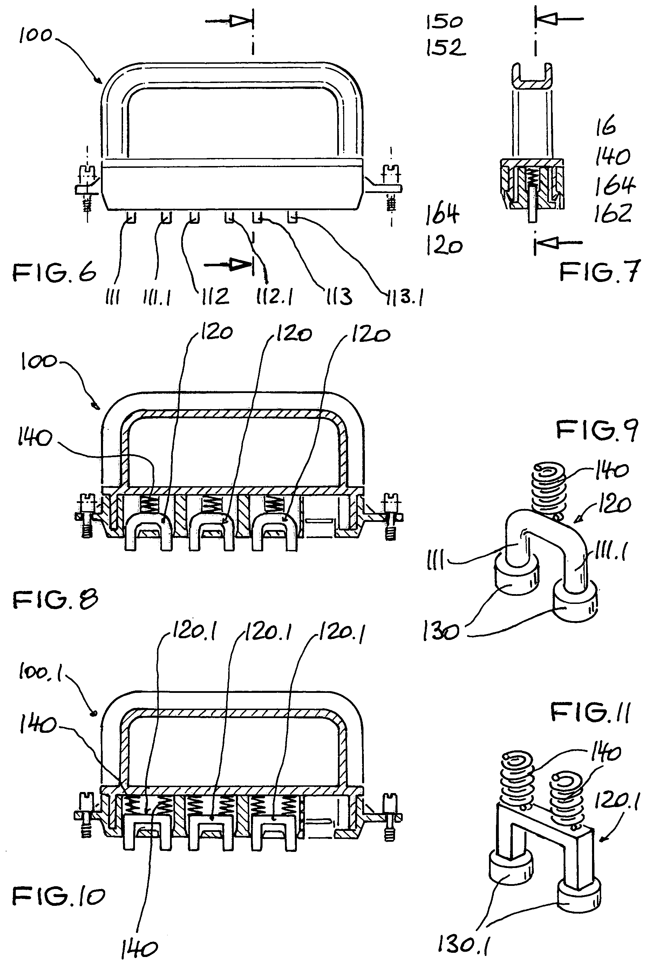

Die Kontaktstifte sind die - bezogen auf die Zeichnung - nach unten herausragenden Kontaktbereiche von drei U-förmigen Überbrückungskontakten 120 des Überbrückungsadapters 100. Jeder der Überbrückungskontakte 120 besitzt zwei nach unten herausragende Kontaktstifte. Bei dem in den Fig. 6 bis 8 dargestellten Ausführungsbeispiel des Überbrückungsadapters 100 ist jeder seiner drei Überbrückungskontakte 120 aus einem Runddraht U-förmig gebogen. Auf jedem der Kontaktstifte kann, wie Fig. 9 zu entnehmen ist, endseitig eine hülsenartige Verdickung 130 aufgebracht sein. Dadurch wird der an sich querschnittsmäßig dünne Kontaktstift endseitig so verbreitert, dass er sicher auf der jeweiligen Klemmschraube 132 (Fig. 4) kontaktmäßig aufliegt, wenn der Überbrückungsadapter 100 an der Anschließvorrichtung 15, wie im vorliegenden Fall mittels der zwei Plombierschrauben 36, 38, angeschraubt ist. Die in der Fig. 4 dargestellte Klemmschraube 132, und Vergleichbares gilt für alle in dieser Reihe angeordneten Klemmschrauben, dient zum Befestigen der Zugangsleitung 102 in der Anschließvorrichtung 15. Über die Klemmschraube 132 kann also ein elektrischer Kontakt mit der entsprechenden Leitungsader, im vorliegenden Beispielsfall gemäß Fig. 4 mit der Zugangsleitung 102, hergestellt werden.

Um sicherzustellen, dass die beiden Kontaktstifte des U-förmigen Überbrückungskontaktes 120 auch sicher auf den beiden zugehörigen Klemmschrauben 132 anliegen, wird der Überbrückungskontakt 120 mittels einer Schraubenfeder 140 gegen die entsprechenden beiden Klemmschrauben 132 gedrückt. Der Überbrückungskontakt 120 hängt dabei an der Schraubenfeder 140. Die Aufhängung ist in geringem Maße wippenartig nachgiebig, so dass durch Zusammendrücken der Feder sichergestellt ist, dass die beiden Kontaktstifte 111 und 111.1 mit Sicherheit auch auf den beiden Klemmschrauben 132 kontaktmäßig anliegen. Je nach Dicke der Kontaktstifte eines Überbrückungskontaktes kann auf die endseitige Verdickung 130 auch verzichtet werden.

Im Gegensatz zu der in den Fig. 7, 8 und 9 dargestellten Ausführungsform ist bei der Ausführungsform einer Überbrückungsadapters 100.1 gemäß Fig. 10 nicht ein Runddraht sondern ein Vierkantstift zu einem U-förmigen Überbrückungskontakt 120.1 verformt. Bei der Ausführungsform gemäß Fig. 11 ist der Überbrückungskontakt 120.1 zusätzlich mit einer endseitig auf seine beiden Kontaktstifte aufgebrachte Verdickung 130.1 versehen.

Zusätzlich ist der Überbrückungskontakt 120.1 statt mit einer Schraubenfeder 140 mit zwei Schraubenfedern 140 versehen. Die beiden Schraubenfedern 140 erlauben ebenfalls eine leicht wippenartig nachgiebige Ausrichtung des Überbrückungskontaktes 120.1 und stellen damit sicher, dass der Überbrückungskontakt 120.1 kontaktmäßig zuverlässig auf jeweils zwei Klemmschrauben 132 einer jeweiligen Leitungsader L1 oder L2 oder L3 aufliegen.

Unabhängig von der Ausführungsform des Überbrückungskontaktes kann derselbe mit einer oder mehreren Federelementen, wie beispielsweise Schraubenfedern 140, ausgestattet sein, damit seine Kontaktstifte sicheren Kontakt mit den Klemmschrauben der verschiedenen Leitungsadern L1, L2, L3 haben können.

Die in der Zeichnung dargestellten Überbrückungsadapter besitzen eine - in der Zeichnung - obere Griffausnehmung 152. Dadurch wird ein Bügelgriff 150 geschaffen, der ein leichtes Hantieren mit dem jeweiligen Überbrückungsadapter ermöglicht.

Jeder der dargestellten Überbrückungsadapter besitzt ein Oberteil 160 und ein Unterteil 162, die aneinander befestigt sind. Im vorliegenen Fall ragen vom Oberteil 160 mehrere, im vorliegenden Fall vier, Haken 164 nach unten heraus, die sich mit Rücksprüngen in der Wandung des Unterteils 162 verhaken und so die beiden Teile aneinander befestigt halten. Statt der Haken 164 könnte auch eine Verschraubung oder eine sonstige Befestigung der beiden Teile vorgesehen werden.

An dem Oberteil 160 sind die Schraubenfedern 140 befestigt, an denen wiederum die verschiedenen Überbrückungskontakte anhängen. Die Kontaktstifte der Überbrückungskontakte ragen durch Öffnungen 166 in dem Unterteil nach unten aus demselben heraus, so wie das in Fig. 4 zu erkennen ist. Die aus dem Unterteil 162 herausragenden Enden der verschiedenen Kontaktstifte sind infolge der vorhandenen Schraubenfedern 140 elastisch nachgiebig gelagert. Beim Aufschrauben eines Überbrückungsadapters auf der Anschließvorrichtung 15 sitzen dadurch seine Kontaktstifte kontaktsicher auf den verschiedenen Klemmschrauben der drei Leitungsadern L1, L2 und L3 auf.

## Patentansprüche

1. Adapter (10) als Befestigungs- und Kontaktiereinrichtung (BKE) für einen jeweils auskragende Kontaktzungen und Befestigungsfüße (24) aufweisenden elektronischen Haushaltszähler (eHZ),
- mit einer den unbefugten Zugang zu den Zugangs- und Abgangsleitungen des Adapters (10) versperrenden und durch eine Verplombung gesicherten Anschließvorrichtung (15),
- mit einer mechanischen Verriegelungsvorrichtung (30) für einen auf dem Adapter (10) kontaktmäßig aufsitzenden eHZ (12),
- wobei die Gegenkontakte (70) des Adapters (10) für die Kontaktzungen des eHZ (12) ausschließlich als Steckkontakte so ausgebildet sind, dass eine Kontaktierung zwischen ihnen ausschließlich durch Verschieben der Kontaktzungen in einer Richtung in die Gegenkontakte (70) hinein erzeugbar ist,
- wobei die Betätigungsvorrichtung (40) für die Verriegelungsvorrichtung (30) unter der durch eine Plombierung geschützte Abdeckung (60) der Anschließvorrichtung (15) vorhanden ist,
- **dadurch gekennzeichnet, dass**
- die Verriegelungsvorrichtung ein hin und her bewegbares Schiebeglied in Form einer Schiebeplatte (30) besitzt,
- die Schiebeplatte (30) in eine derartige Lage zwischen zumindest einen der Befestigungsfüße (24) eines eHZ (12) schiebbar ist, dass zumindest dieser Fuß (24) lagefixiert am Adapter (10) vorhanden ist,
- die Schiebeplatte (30) rahmenförmig so ausgebildet ist, dass sie den Kontaktierbereich zwischen einem eHZ (12) und dem Adapter (10) einrahmt,
- die Schiebeplatte (30) einen linken und rechten Plattensteg (36, 38) besitzt, die beide an ihrem oberen und unteren Ende durch einen oberen beziehungsweise einen unteren Quersteg (32, 34) fest miteinander verbunden sind,
- ein Griff (40) am unteren Quersteg (34) vorhanden ist, mit dem die Schiebeplatte (30) in den Bereich der Anschließvorrichtung (15) hineinragt und der unter der plombierbaren Abdeckung (60) der Anschließvorrichtung (15) vorhanden ist.

2. Adapter nach Anspruch 1,
- **dadurch gekennzeichnet, dass**
- die Gegenkontakte (70) für eine Stromstärke bis etwa 100 Ampere ausgelegt sind.

3. Adapter nach einem der vorstehenden Ansprüche,
- **dadurch gekennzeichnet, dass**
- eine Zählersteckklemme an der Anschließvorrichtung (15) anschließbar oder angeschlossen ist.

## Claims

1. Adapter (10) as a fastening and contact-making device (BKE) for an electronic domestic meter (eHZ) which has respectively projecting contact tongues and fastening feet (24),
- having a connecting apparatus (15) which blocks unauthorized access to the access and outgoing lines of the adapter (10) and is secured by a lead seal,
- having a mechanical locking apparatus (30) for an eHZ (12) which is seated with contact on the adapter (10),
- wherein the mating contacts (70) of the adapter (10) for the contact tongues of the eHZ (12) are designed solely as plug-in contacts such that a contact-connection between them can be produced solely by movement of the contact tongues into the mating contacts (70) in one direction,
- wherein the operating apparatus (40) for the locking apparatus (30) is present beneath the cover (60) of the connecting apparatus (15), which cover is protected by a lead seal,
- **characterized in that**
- the locking apparatus has a sliding element, which can be moved back and forth, in the form of a sliding plate (30),
- the sliding plate (30) can be slid into a position between at least one of the fastening feet (24) of an eHZ (12) such that at least this foot (24) is present in a fixed position on the adapter (10),
- the sliding plate (30) is designed in the form of a frame such that it frames the contact-making region between an eHZ (12) and the adapter (10),
- the sliding plate (30) has a left-hand-side and right-hand-side plate web (36, 38), which two plate webs are fixedly connected to one another at their upper and lower end by an upper and, respectively, a lower transverse web (32, 34),
- a grip (40) is present on the lower transverse web (34), the sliding plate (30) protruding into the region of the connecting apparatus (15) by way of the said grip and the said grip being present beneath the lead-sealable cover (60) of the connecting apparatus (15).

2. Adapter according to Claim 1,
- **characterized in that**
- the mating contacts (70) are designed for a current of up to approximately 100 amperes.

3. Adapter according to either of the preceding claims,
- **characterized in that**
- a meter plug-in terminal can be connected or is connected to the connecting apparatus (15).

## Revendications

1. Adaptateur (10) en tant que dispositif de fixation et de contact (BKE) pour un compteur électronique domestique (eHZ) comportant respectivement des languettes de contact et des pieds de fixation (24) en saillie,
- comportant un dispositif de raccordement (15) empêchant l'accès non autorisé aux lignes d'accès et de sortie de l'adaptateur (10) et sécurisé par plombage,
- comportant un dispositif de verrouillage mécanique (30) pour un dispositif eHZ (12) installé en contact avec l'adaptateur (10),
- dans lequel les contacts complémentaires (70) de l'adaptateur (10) pour les languettes de contact du dispositif eHZ (12) sont exclusivement réalisés sous la forme de contacts enfichables de manière à ce qu'un contact entre eux puisse être réalisé exclusivement en faisant coulisser dans un sens les languettes de contact dans les contacts complémentaires (70),
- dans lequel le dispositif d'actionnement (40) destiné au dispositif de verrouillage (30) est placé sous le couvercle protégé par plombage (60) du dispositif de raccordement (15),
- **caractérisé en ce que**
- le dispositif de verrouillage comporte un élément coulissant sous la forme d'une plaque coulissante (30) qui peut être déplacée par va-et-vient,
- la plaque coulissante (30) peut être poussée à une position située entre au moins l'un des pieds de fixation (24) d'un dispositif eHZ (12) de manière à ce qu'au moins ce pied (24) soit fixé en position sur l'adaptateur (10),
- la plaque coulissante (30) est réalisée sous la forme d'un cadre de manière à encadrer la zone de contact entre un dispositif eHZ (12) et l'adaptateur (10),
- la plaque coulissante (30) présente des nervures de plaque gauche et droite (36, 38), qui sont toutes deux respectivement fermement reliées l'une à l'autre au niveau de leurs extrémités supérieure et inférieure par une nervure transversale supérieure et une nervure transversale inférieure (32, 34),
- il est prévu sur la nervure inférieure (34) une poignée (40) avec laquelle la plaque coulissante (30) fait saillie dans la zone du dispositif de raccordement (15) et qui est prévue sous le couvercle pouvant être plombé (60) du dispositif de raccordement (15).

2. Adaptateur selon la revendication 1,
- **caractérisé en ce que**
- les contacts complémentaires (70) sont conçus pour une intensité de courant allant jusqu'à environ 100 ampères.

3. Adaptateur selon l'une des revendications précédentes,
- **caractérisé**
- **en ce qu'**une fiche de raccordement peut être raccordée ou est raccordée au dispositif de raccordement (15).
